# EUROPEAN PATENT SPECIFICATION

(11) **EP 0 563 156 B1**
(45) Date of publication and mention of the grant of the patent: **08.04.1998**
(21) Application number: 92901498.3
(22) Date of filing: 19.12.1991
(51) Int. Cl.: G03F 7/07, G03F 7/06, B41N 1/14

(54) **PLANOGRAPHIC PRINTING PLATE PRECURSOR**
FLACHDRUCKPLATTEVORSTUFE
PRECURSEUR DE PLAQUE D'IMPRESSION PLANOGRAPHIQUE

(30) Priority: 20.12.1990 EP 90203452
(43) Date of publication of application: 06.10.1993
(73) Proprietor: AGFA-GEVAERT N.V., 2640 Mortsel (BE)
(72) Inventor: STEVENS, Marc, Petrus, B-9180 Belsele (BE); MARIEN, August, Marcel, B-2260 Westerlo (BE); VERHEYEN, Joannes, Maria, B-2520 Ranst (BE); PLESSERS, Patrick, B-3000 Leuven (BE)
(86) International application number: EP9102466
(87) International publication number: WO9211579

(56) References cited:
- FR-A- 1 136 733
- FR-A- 1 384 488

## Description

The present invention relates to planographic printing plate precursors characterised by a transparent thermoplastic film support whilst maintaining the advantages of conventional metal-based printing plates more in particular the present invention relates to planographic printing plate precursors, suitable for producing planographic printing plates by the application of the silver complex diffusion transfer method.

### Background of the invention.

The methods for producing planographic printing plates by application of the silver complex diffusion transfer method are well known to those skilled in the art.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. For example, typical Planographic printing plates are disclosed e.g. in Japanese Examined Patent Publication (Kokoku) 30562/73, Japanese Unexamined Patent Publications (Kokai) Nos. 21602/78, 103104/79, 9750/81 etc.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. Thus, it is known e.g. from the United Kingdom Patent Specification 1,241,661 to produce a planographic printing plate consisting of a sheet material comprising an outer hydrophilic colloid layer on the surface of which there is concentrated a silver image stemming from an underlying exposed silver halide emulsion layer by the silver complex diffusion transfer reversal process.

Commercially available DTR materials according to this conventional method which can be processed to planographic printing plates are marketed e.g. by MITSUBISHI PAPER MILLS LTD under the trade name SILVERMASTER and by AGFA-GEVAERT N.V. under the trade name SUPERMASTER.

According to more recent developments new types of DTR elements are used as recording materials for phototype-setting and image-setting devices which employ laser beams as their output energy source. According to these so-called "direct to plate" methods these laser-exposed DTR materials are transformed in direct-to-use printing plates containing type- and image information, thus avoiding the intermediate steps as in conventional pre-press work flow.

For example, planographic DTR elements suited for exposure by helium-neon laser (HeNe) or light emitting diode (LED), are disclosed in US-P 4,501,811 and Japanese Unexamined Patent Publication (Kokai) Nos. 71055/84 and 75838/85. A commercially available DTR material spectrally sensitized for HeNe exposure is marketed by AGFA-GEVAERT N.V. under the trade name SETPRINT HeNe-plate PP 410 p.

More particulars about the planographic DTR elements referred to above are described in EP-A 423 399.

The support of the DTR material may be opaque or transparent, e.g. a paper support or resin support.

Poly(ethylene terephthalate) film is generally used as support for photographic film in general and DTR monosheet materials in particular. One of the main advantages of a resin support over a paper support is the transparancy of the resin support.

A planographic DTR element with a transparent film support, such as the material marketed by Agfa-Gevaert N.V. under the trademark SUPERMASTER SFP-TR, has the inherent advantage that, thanks to its transparent support, it may be imagewise illuminated in a conventional reprographic vertical camera, such as the reprocameras marketed by Agfa-Gevaert N.V. under the trademark REPROMASTER. Thereby the original paste-up, comprising e.g. typesetting paper, halftones, bits and pieces on plain paper, is placed on the copyboard of the reprocamera and the planographic DTR element is positioned on the film holder, with its backing facing the original. The above described working method enables customers having a conventional reprocamera, without having to return to reversing optics, to expose the DTR-element through the back of its transparent support. So the reprocamera can be used for planographic plate exposure without any additional cost. The wide exposure latitude of the DTR-element further ensures dependable results and further savings.

For reprocameras with a reversing mirror the exposure of a planographic element can be made through the emulsion of said element. However also in this case, there is advantage in using planographic elements with a transparent film support. After exposure and subsequent processing of a planographic printing plate with a transparent support, the printing image on said plate can readily and easily be evaluated by putting said plate on a light table.

Apart from the advantages set forth above, planographic printing plates based upon a resin support ensure increased mechanical strength comprising improved plate rigidity and dimensional stability as compared to plates based upon a paper support.

However when very high standards in respect of dimensional stability, easy handling of the plates, and printing endurance are set forth, planographic printing plates based on a metal support, such as aluminium printing plates, still offer distinct advantages over printing plates on a resin support.

On the other hand, planographic printing plates on metal support such as aluminium printing plates, are more expensive than their resin support counterparts and the quality of their printing image cannot be readily evaluated on a light table as their support is opaque. Further these plates are conventionally produced with the silver halide diffusion transfer process in a two-sheet system, the metal plate thereby acting as the receptor material in the two-sheet DTR-system. A two-sheet DTR element however has the disadvantage over a monosheet element, that along with the transfer of the image from the photographic light-sensitive sheet to the DTR-receptor element, image defects such as registration misfits are likely to occur.

Apart from the above defined DTR silver halide layer as photosensitive layer in the production of printing plates, there also exists such light-sensitive layers on the basis of diazonium resins or salts, photopolymers etc., which can equally well be coated on either a transparent (polyester) resin support or an opaque aluminium support.

Apart from the lithographic printing plate precursors comprising a light-sensitive layer, there also exists printing plate precursors comprising hydrophilic non-light-sensitive layers on which an image can be formed e.g. by an electrophotographic or thermal transfer process, such as disclosed e.g. in EP 0 405 016 or EP 91200468.6.

In view of the above, there is a need to combine the advantages of planographic printing plates with metal (aluminium) support, with those of printing plates with a transparent film support.

### Object of the invention

It is therefore an object of the present invention to provide planographic printing plates with a transparent film support having the advantages of conventional metal-based printing plates. More in particular it is an object of the present invention to provide planographic printing plates with a transparent film support, high dimensional stability and easy handling.

Other objects will become apparent from the description hereinafter.

### Summary of the invention.

In accordance with the present invention we have now found that the above objects may be accomplished by providing a planographic printing plate precursor, comprising a silver halide emulsion and a nuclei containing surface layer coated on a thermoplastic resin support wherein :
(i) said thermoplastic resin support has a thickness between 200 µm and 400 µm,
(ii) said thermoplastic resin support has a light transmittance amounting to at least 70 % at 360 nm and to at least 85 % at 579 nm, and
(iii) said thermoplastic support is made of a copolymer comprising ethyleneterephthalate as the main recurring polymer units, said copolymer being the polycondensation reaction product of ethylene glycol and terephthalic acid, ethylene glycol being substituted by another diol, and/or terephthalic acid being substituted by another aromatic dicarboxylic acid, either substitution(s) amounting to between 4 and 15 mol percent with respect to ethylene glycol and/or terephthalic acid, or said copolymer being the polycondensation reaction product of ethylene glycol and dimethylterephthalate, ethylene glycol being substituted by another diol, and/or dimethylterephthalate being substituted by the dimethyl ester of another aromatic dicarboxylic acid, either substitution(s) amounting to between 4 and 15 mol percent with respect to ethylene glycol and/or dimethylterephthalate.

According to a preferred embodiment of our invention, the copolymer of the transparent resin support is the polycondensation reaction product of ethylene glycol and terephthalic acid, the latter being substituted by isophthalic acid for between 4 and 15 mol percent, or said copolymer being the polycondensation reaction product of ethylene glycol and dimethylterephthalate, the latter being substituted by dimethylisophthalate for between 4 and 15 mol percent.

Further preferred embodiments will become apparent from the description hereinafter.

### Detailed description of the invention.

The thickness of the thermoplastic resin support, made of polyethylene terephthalate, of the planographic mono-sheet DTR plates presently marketed by Agfa-Gevaert N.V. under the trademark SUPERMASTER varies between 100 and 175 µm (micron). 175 µm (microns) is also the usual thickness with regard to dimensional stability and ease of handling and manipulation of the thermoplastic resin supports for radiographic films for medical diagnostic purposes, presently available on the market, and marketed e.g. by Agfa-Gevaert under the trademark CURIX.

The objects set forth above of very high dimensional stability, which goes along with the requirement of easy handling of the plates, in particular for large-size plates, can be met by increasing the thickness of the thermoplastic resin support, made of e.g. polyethylene terephthalate, of the planographic printing plate. However, when polyethylene terephthalate films are conventionally produced, films with thicknesses above approx. 200 µm (microns) tend to loose their transparent character and become dull and/or opaque.

As polyester and in particular polyethylene terephthalate polymer (PETP) is an important raw material for the manufacture of i.a. filaments and films, more in particular photographic films, the processes for manufacturing PETP-granulate and converting said PETP-granulate to film are well known to those skilled in the art.

Film materials are generally obtained by melt-extrusion of the polyester through an extruder, rapidly cooling the melt-extruded sheet on the surface of a cooling drum and then biaxially orienting the solidified material in longitudinal and transverse direction.

The PETP which is melt extruded can be prepared according to two main methods.

In a first method there is an ester exchange reaction between dimethyl terephthalate (DMT) and ethylene glycol (EG) to form bis(/-hydroxyethyl-terephthalate (BHET) whereupon polycondensation takes place. Both in the ester exchange reaction and in the polycondensation reaction catalysts are used : e.g. a zinc, magnesium, manganese, or cobalt salt or mixtures thereof in particular manganese acetate as ester exchange catalyst, and antimony compounds and/or germanium compounds (such as antimony and/or germanium dioxide) as polycondensation catalyst, and stabilisers such as e.g. phosphorus compounds.

In a second method the BHET is obtained by direct esterification of terephthalic acid (PTA) with ethylene glycol (EG). Antimony trioxide and/or germanium dioxide are also added as polycondensation catalyst and a phosphorus compound may be added as stabilizer.

According to our invention, in the so-called direct esterification process for the production of polyethylene terephthalate, between 4 and 20 mol percent of the ethylene glycol should be substituted by another diol such as 1,3-propanediol, 1,4-butanediol, neopenthylglycol or 1,4-cyclohexanedimethanol, and/or between 4 and 20 mol percent of the terephthalic acid should be substituted by another aromatic dicarboxylic acid such as isophthalic, phthalic, 2,5-, 2,6- and 2,7- napthalene dicarboxylic acid, diphenyl dicarboxylic acid or hexahydroterephthalic acid. In principle, the terephthalic acid could also be replaced between 4 and 20 mol percent by another dicarboxylic aliphatic acid such as succinic acid, sebacic acid, adipic acid, azelaic acid or the like. However, the substitution of the terephthalic acid by another dicarboxylic aromatic acid is preferred in view of the mechanical strength including i.a. dimensional stability, of the resulting thermoplastic film support.

According to an alternative embodiment of our invention, when the so-called ester-exchange reaction method is used for the production of polyethylene terephthalate, between 4 and 20 mol percent of the ethylene glycol should be substituted by one of the diols abovementioned, and/or between 4 and 20 mol percent of the dimethylterephthalate should be subsituted by the dimethylester of one of the aromatic dicarboxylic acids above mentioned.

According to a preferred embodiment of our invention, when the direct esterification process is used for the production of PETP, between 4 and 20 mol % of terephthalic acid should be substituted by isophthalic acid, and when the ester exchange process is used, between 4 and 20 mol % of dimethylterephthalate should be substituted by dimethylisophthalate.

According to a still more preferred embodiment the molar ratio of terephthalate/isophthalate units in the copolymer resin of the thermoplastic resin support is comprised between 85:15 and 96:4, whereas the average thickness of the thermoplastic resin support is 290 µm (micron). As will be clarified hereinafter in the Examples, the clarity and/or transparancy of the thermoplastic film support of the planographic printing plate of our invention should preferably be such that the light transmittance of the thermoplastic resin support amounts to at least 70 % at 366 nm and to at least 85 % at 579 nm.

Particulars about the direct esterification method are described in e.g. EU-A-0105 522 and EU-A-0159 817. Particulars about the first PETP production method (the ester exchange reaction method) may be found e.g. in GB-A-1 221 788, GB-A-1 274 858, GB-A-1 108 096, GB-A-1 185 984 and GB-A-1 091 234.

Particulars about the film-forming process of PETP starting from PETP-granulate may be found in GB-A-1 269 127, GB-1-1 312 263 and EU-A- 0 022 278.

The film support according to the present invention is made according to the conventional steps of drying the granulate, followed by melt extrusion upon a quenching drum, stretching the film first in the longitudinal direction, subsequently in transverse direction, finally followed by heat setting the biaxially stretched film.

More in particular, in the extrusion process of making the polymer film, the molten polymer is extruded through a slot-like orifice and the extruded polymer is received on a quenching drum or drums on which the temperature of the extruded film is lowered sufficiently rapidly through the softening range of the polymer to obtain a substantially amorphous film. The cooling capacity of the quenching drum, along with the cooling of the molten film by air-blowing is a critical factor in obtaining a substantially amorphous film.

Also in order to obtain a rapid quenching of the film, it is important that the heat transfer from the film to the quenching drum surface be high. Good heat transfer may be obtained when the film is securely adhered to the quenching drum surface by depositing electrostatic charges to the upper surface of the molten film from a corona-discharge station, prior to the point where the film first contacts with its lower surface the quenching surface which is electrically grounded. Although this process is conventionally applied when melt-extruding polyester films, the industrial execution of this process is hampered by various phenomenons, which are inherent to ionization discharging. Therefore, for producing the thermoplastic resin film suitable as support for the planographic mono-sheet DTR printing plate precursor according to our invention, the process and apparatus as described in the already cited US-P-4,310,294 is preferably employed.
According to said specification, the process for melt-extruding a polyester film comprises extruding the polyester in the form of a continuous film from the extrusion die onto a moving quenching drum, maintaining an electrical potential difference between said quenching drum and the extrusion die, the magnitude of such potential difference being sufficient to improve the adherence of said film to said quenching drum, and finally withdrawing the solidified film from the quenching drum, for further treatment, including longitudinal and transverse stretching.

By stretching the quenched film longitudinally and transversely while the polymer is at the lower end of the softening range, above the second order transition temperature of the polymer, the film can be subjected to molecular orientation leading to an improvement in various physical properties of the film, notably the tensile strength.

The longitudinal stretching of the film is usually achieved by passing the film first around a series of slowly rotating rollers and then around a series of rollers which are rotated more rapidly, and by heating the film between the two series of rollers to a temperature such that the film undergoes plastic elongation under the traction forces imposed on it due to the different speeds of the two series of rollers.

The heating of the film to the desired stretching temperature may occur in two stages as in the conventional methods. In the first stage the film is heated to a temperature that is somewhat higher than the second order transition temperature (hereinafter called Tg) of the film. This first stage heating is effected by heating the first series of rollers. The first stage heating temperature should not exceed 82°C because at temperatures higher than 82°C the film starts to stick to the roller surfaces. In the second heating stage the film is heated to the stretching temperature by means of IR radiation. A common stretching temperature of the film is within the range 85° to 95°C.

The cooling of the film after stretching is effected by cooling the more rapidly rotating rollers to a temperature well below the Tg of the film but above the dew point of the atmosphere in order to avoid condensation effects. The described steps of heating, cooling and stretching a film are disclosed in US-A-4093695 to a process for making polymeric film.

For the film support according to our invention, the following process of longitudinally stretching the PETP-film is preferentially applied. This process comprises longitudinally stretching a substantially amorphous film during its longitudinal conveyance by exerting longitudinal stretching forces on the film by first and second traction means located at spaced positions along the path of conveyance of the film, while heating the film between said first and second traction means by means of infrared radiation to a temperature such that the film undergoes plastic elongation under said stretching forces, and cooling the stretched film. In this proces the temperature of the first traction means is not higher than 65°C, the said heating is achieved by directly and symmetrically exposing both sides of the film first to diffused IR-radiation which causes the film temperature to increase but insufficiently for plastic elongation to occur thereby preheating the film, and then to concentrated infrared radiation which heats the film to a temperature between 100° and 120°C whereby rapid plastic elongation of the film occurs under said stretching forces, and whereby the film is rapidly cooled to below its second order transition temperature, before it reaches the second traction means. Then the film is immersed in a bath of cooling liquid which is continuously renewed at the region where the film enters the bath, and wherein the liquid surface at that region is kept quiescent.

More particulars about this process of longitudinally stretching are described in EU-A-0022278, cited supra.

After the film has left the cooling liquid bath, drying of the liquid-cooled film may occur by means of squeezing means and heaters. Therefore the method and apparatus as described in EP-A 402 530 and EP-A 402 531 should preferentially be used.

A typical stretch ratio of the film in longitudinal direction is 3.3:1, while the film is kept at a temperature of approx. 100°C. The typical stretch ratio of the film in transverse direction is also 3.3:1. The biaxially stretched film should finally be heat-set at a temperature of approx. 205°C.

Heat-setting or heat-relaxing biaxially oriented film involves holding the film at a reduced longitudinal tension while it is heated. Such heat-relaxed or annealed biaxially oriented film exhibits a high degree of dimensional stability and resistance to shrinkage at elevated temperatures up to the heat-relaxing temperature. The principle of heat-relaxing and heat-relaxing devices are described in e.g. US-2,779,684, US-4,160,799 and US-3,632,726. During heat-setting a film, the film should be kept at a temperature between the glass transition temperature and the melt temperature of the polymer, while the film is prevented from shrinking, so as to increase the crystallinity of the film. Such an enhanced crystallinity offers the heat-relaxed film its higher mechanical strength, inclusive of its improved dimensional stability. In view hereof, the amount of diol substituting the ethylene glycol or the amount of dicarboxylic aromatic acid substituting the terephthalic acid in the polyethylene terephthalate copolymer chain should be limited to maximum 20 and preferably 15 % mol percent. When higher substitution percentages are applied, the increased crystallinity of the biaxially oriented film cannot be achieved by heat-setting and the resulting film shows insufficient dimensional stability.

After the heat-setting the beaded edges of the film are trimmed, the margins of the film are knurled and the final film is round up.

The invention will further be illustrated by means of examples. Unless as otherwise explicitly stated, all ratios are to be understood as mole-ratios.

### Comparative example 1.

Polyethylene terephthalate polymer PETP was prepared starting from pure terephthalic acid and ethylene glycol as raw materials according to the direct esterification and polymerisation process as described earlier. The following catalyst combination was used :
0.00014 mol Sb/mol PETP
0.00004 mol Ge/mol PETP
0.00035 mol Mg/mol PETP.

The following stabiliser/antioxydants combination was used : 0.0002 mol Irganox 1222/mol PETP, being the diethyl ester derivative of 3,5-di-tert butyl-4-hydyroxy benzylfosfonic acid available from Ciba-Geigy AG, 4002 Basel, Switserland and 0.8 x 10⁻⁴ mol Weston 600/mol PETP, being a di-isodecyl-pentaerythritoldiphosphite available from Borg-Warner Holdings Corp., 200 South Michigan Avenue, Chicago Il. 60604, USA.

The resulting polymer showed an intrinsic viscosity of 0.555-0.630 dl/g and a crystalline melting point of 263°C. The intrinsic viscosity was measured on a solution of 0,5 g of PETP in 100 ml of a mixture of 40 parts by weight of phenol and 60 parts by weight of 1,2-dichlorobenzene, in the way as described in ISO 1628/1 and ISO 1628/5 Standards.

Said polymer was directly fed in melt form to a PETP-extrusion apparatus as described earlier whereby the longitudinal and transverse stretch ratios amounted to 3.3:1, resp. 3.3:1 and the average thickness of the resulting film was 290 µm (micron).

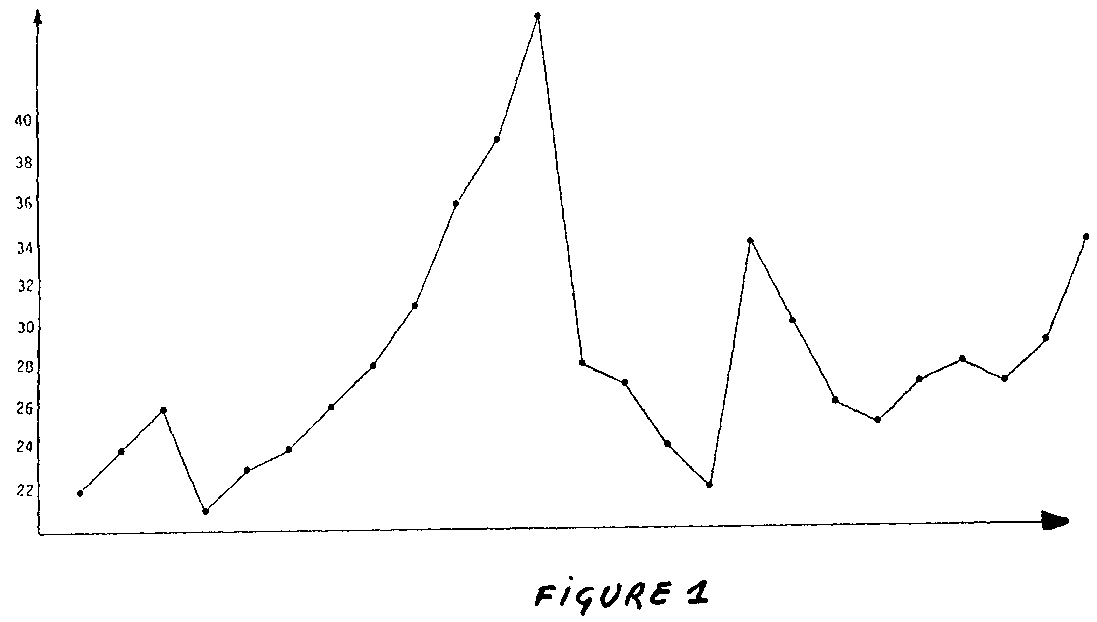

The haze as measured over the entire width of the resulting film roll is shown in figure 1. The abscis in this figure 1 indicates various positions over the film roll width, whereas in ordinate the maximum number of film supports are set forth which could be laid on top of each other, whereby a black and white contrast line underneath said pile of film supports could still be clearly discerned by the naked eye. The higher the clarity of the film support, the higher the number of film supports that could be laid on top of each other still allowing a clear distinction of the underlying black/white contrast line. From this figure it is clear that not only the average non-transparancy or haze of the resulting film was such that a planographic printing plate precursor with such film support was not suitable for being illuminated through the back, but also that the occurrence of haze was quite non-uniform over the entire film width.

Further the following Table I shows the measurements of the light transmission of the resulting film at 360 and 579 nm respectively. The values of Table I result from measurements effected at three places regularly spaced over the entire width of the film roll, and at regular intervals in the longitudinal direction of the film roll.

In this table the first three columns set forth the measurements of light transmittance expressed in % effected at 360 nm at three different locations (near the edges and around the middle) of the entire film roll width. The last three columns set forth the measurements effected at 579 nm, carried out at the same locations over the film width. The lines 1 to 4 set forth the results of these measurements carried out at regular intervals in the longitudinal direction of the film roll. The values for light transmittance as set forth in this table result from measurements of the light intensity transmitted through the film versus the intensity of the impinging light on the film expressed in percent values. Said light intensities were measured by a conventional spectrofotometer such as the model 'Visual Spectrofotometer Lambda 1' marketed by the Perkin-Elmer Corporation, 761 Main Avenue, Norwalk, USA.

**Table I**

| measurement nr. | at 360 nm | | | at 579 nm | | |
|---|---|---|---|---|---|---|
| 1. | 44 | 55 | 30 | 82 | 87 | 77 |
| 2. | 58 | 55 | 35 | 86 | 86 | 78 |
| 3. | 52 | 62 | 50 | 85 | 88 | 85 |
| 4. | 47 | 54 | 52 | 83 | 87 | 86 |

The norm for light transmittance for film support for graphic arts photographic materials amounts to approximately 70 % at 360 nm and to approximately 85 % at 579 nm. From the above Table I it clearly results that the above norm for clarity for film supports for photographic use, is not met by the PETP-film as described, in particular at 360 nm.

Further the above table confirms the non-uniformity of the haze of the PETP-film in transverse and longitudinal direction, as was already apparent from the Figure 1.

### Comparative Example 2

Polyethylene terephthalate/isophthalate copolymer was prepared starting from ethylene glycol on the one hand and terephthalic/isophthalic acid on the other hand as raw materials according to the direct esterification and polymerisation process as described earlier. The ratio of terephthalic to isophthalic acid amounted to 96,3 : 3,7.

The same catalyst/stabiliser combination was used as described under the comparative example 1; the resulting polymer showed the same intrinsic viscosity as in the comparative example 1 and a melting point of 257 °C. After polycondensation took place, the copolymer was cooled and granulated according to conventional means; the copolymer granules were than transported to a PETP-film extrusion apparatus where they were melt-extruded on a cooling drum, biaxially stretched and annealed whereby the average thickness of the resulting film was 290 µm (micron). Although the overal occurrence of haze was slightly less as compared to the film of comparative example 1, the thermoplastic resin was not suitable for being used as support film for the planographic mono-sheet DTR printing plate precursor meeting the objects of transparency set forth above. So, apparently the cooling of the melt-extruded film by the air-blowing and the cooling capacity of the quenching drum along with the partial substitution of terephthalic acid by isophthalic acid did not suffice to avoid the occurrence of haze on the film.

### Example 1.

Polyethylene terephthalate/isophthalate copolymer was prepared starting from ethylene glycol on the one hand and terephthalic/isophthalic acid on the other hand as raw materials according to the direct esterification and polymerisation process as described earlier. The ratio of terephthalic to isophthalic acid amounted to 95,5 : 4,5.

The same catalyst/stabiliser combination was used as described under the comparative example 1; the resulting polymer showed the same intrinsic viscosity as in the comparative example 1 and a melting point of 255 °C.

Said polymer was also directly fed in melt form to a PETP-extrusion apparatus as described earlier operating under the same conditions as set forth under the comparative example, so that the average thickness of the resulting film amounted to 290 µm (micron).

The following Table II shows the measurements of the light transmission of the resulting film at 360 and 579 nm respectively.

The values of Table II result from measurements effected regularly over the entire width of the film roll and at regular intervals in the longitudinal direction of the film roll.

**Table II**

| Measurement nr. | Light transmittance at | |
|---|---|---|
| | 360 nm | 579 nm |
| 1 | 70.8 | 86.6 |
| 2 | 71.2 | 85.5 |
| 3 | 68.1 | 86.5 |
| 4 | 69.3 | 85.0 |

From the above table II it results that in comparison to the values set forth in Table I, the film support made of a copolymer of ethylene glycol and terephthalic acid whereby the latter compound is substituted to a sufficient degree by isophthalic acid shows a substantial increase of clarity or transparancy as illustrated by the above light transmittance values, in particular at 360 nm.

Further the uniformity of clarity over the transverse and longitudinal direction of the film was also substantially increased as compared to the comparative film roll.

Consequently the film support according to this example was suitable as transparent dimensionally stable support for photographic films, in particular for planographic mono sheet DTR printing plates.

Therefore, a silver halide emulsion layer and a nuclei containing surface layer were coated on said transparent support according to the procedure set forth under example 1 of the already cited EP-A 423 399. The planographic printing plate precursor could easily be illuminated through its backside in a conventional reprocamera, without reversing optics. After processing the quality of the printing image could easily and readily be evaluated on a light table and the planographic printing plate showed excellent dimensional stability, ease of handling and high printing endurance.

### Example 2

The procedure as set forth above under example 1 was repeated with the difference however that the ratio of terephthalic to isophthalic acid amounted to 95:5 and whereby the average thickness of the resulting film also amounted to 290 µm (micron). The results in terms of occurence of haze and light transmittance were slightly improved in comparison to the results set forth above under example 1.

### Example 3

The procedure as set forth above under Comparative example 2 was repeated with the difference however that the ratio of terephthalic to isophthalic acid amounted to 95,5 : 4,5, and that trimethylphosphate was used as stabiliser instead of Weston 600. The results in terms of occurence of haze and light transmittance of the resulting film were comparable with the results of the film produced according to the procedure set forth in Example 1.

## Claims

1. Planographic printing plate precursor, comprising a silver halide emulsion and a nuclei containing surface layer coated on a thermoplastic resin support wherein :
(i) said thermoplastic resin support has a thickness between 200 µm and 400 µm,
(ii) said thermoplastic resin support has a light transmittance amounting to at least 70 % at 360 nm and to at least 85 % at 579 nm, and
(iii) said thermoplastic support is made of a copolymer comprising ethyleneterephthalate as the main recurring polymer units, said copolymer being the polycondensation reaction product of ethylene glycol and terephthalic acid, ethylene glycol being substituted by another diol, and/or terephthalic acid being substituted by another aromatic dicarboxylic acid, either substitution(s) amounting to between 4 and 15 mol percent with respect to ethylene glycol and/or terephthalic acid, or said copolymer being the polycondensation reaction product of ethylene glycol and dimethylterephthalate, ethylene glycol being substituted by another diol, and/or dimethylterephthalate being substituted by the dimethyl ester of another aromatic dicarboxylic acid, either substitution(s) amounting to between 4 and 15 mol percent with respect to ethylene glycol and/or dimethylterephthalate.

2. Planographic printing plate precursor according to claim 1 or 2 wherein said copolymer is the polycondensation reaction product of ethylene glycol and terephthalic acid, the latter being substituted by isophthalic acid for between 4 and 15 mol percent, or said copolymer being the polycondensation reaction product of ethylene glycol and dimethylterephthalate, the latter being substituted by dimethylisophthalate for between 4 and 15 mol percent.

3. Planographic printing plate precursor according to claim 1 further characterised in that the average thickness of the thermoplastic resin support is 290 micron.

## Patentansprüche

1. Ein Flachdruckplattenvorläufer mit einer Silberhalogenidemulsionsschicht und einer Entwicklungskeime enthaltenden Oberflächenschicht, die auf einen thermoplastischen Harzträger aufgetragen sind, wobei
(i) die Stärke des thermoplastischen Harzträgers zwischen 200 und 400 µm liegt,
(ii) der Lichtdurchlaßgrad des thermoplastischen Harzträgers wenigstens 70% bei 360 nm und wenigstens 85% bei 579 nm beträgt, und
(iii) der thermoplastische Träger aus einem Copolymeren mit Ethylenterephthalat als wichtigsten sich wiederholenden Polymereinheiten zusammengesetzt ist, wobei das Copolymere das Polykondensationsreaktionsprodukt von Ethylenglycol und Terephthalsäure ist, wobei Ethylenglycol durch einen anderen Diol und/oder Terephthalsäure durch eine andere aromatische Dicarbonsäure substituiert ist und diese Substitution(en) in einer Menge zwischen 4 und 15 mol-% für Ethylenglycol und/oder Terephthalsäure erfolgt (erfolgen), oder wobei das Copolymere das Polykondensationsreaktionsprodukt von Ethylenglycol und Dimethylterephthalat ist, wobei Ethylenglycol durch einen anderen Diol und/oder Dimethylterephthalat durch den Dimethyl-Ester einer anderen aromatischen Dicarbonsäure substituiert ist, wobei die Substitution(en) in einer Menge zwischen 4 und 15 mol-% für Ethylenglycol und/oder Dimethylterephthalat erfolgt (erfolgen).

2. Flachdruckplattenvorläufer nach Anspruch 1, dadurch gekennzeichnet, daß das Copolymere das PolykondensationsReaktionsprodukt von Ethylenglycol und Terephthalsäure ist, wobei die Terephthalsäure in einer Menge zwischen 4 und 15 mol-% durch Isophthalsäure substituiert ist, oder das Copolymere das Polykondensationsreaktionsprodukt von Ethylenglycol und Dimethylterephthalat ist, wobei das Dimethylterephthalat in einer Menge zwischen 4 und 15 mol-% durch Dimethylisophthalat substituiert ist.

3. Flachdruckplattenvorläufer nach Anspruch 1, ebenfalls dadurch gekennzeichnet, daß die durchschnittliche Stärke des thermoplastischen Harzträgers 290 µm beträgt.

## Revendications

1. Un précurseur de plaque d'impression planographique comprenant une couche d'émulsion à l'halogénure d'argent et une couche superficielle contenant des germes appliquées sur un support de résine thermoplastique,
(i) le support de résine thermoplastique présentant une épaisseur comprise entre 200 et 400 µm,
(ii) le support de résine thermoplastique présentant un degré de transmission de lumière d'au moins 70% à 360 nm et d'au moins 85% à 579 nm, et
(iii) le support thermoplastique étant composé d'un copolymère comprenant de l'éthylène-téréphtalate comme unités polymères structurales principales, le copolymère étant le produit de la réaction de polycondensation d'éthylèneglycol et d'acide téréphtalique, l'éthylèneglycol étant substitué par un autre diol et/ou l'acide téréphtalique étant substitué par un autre acide dicarboxylique aromatique, la (les) substitution(s) ayant lieu dans une quantité comprise entre 4 et 15 moles % pour l'éhylèneglycol et/ou l'acide téréphtalique, ou le copolymère étant le produit de la réaction de polycondensation d'éthylèneglycol et de diméthyltéréphtalate, l'éthylèneglycol étant substitué par un autre diol et/ou le diméthyltéréphtalate étant substitué par l'ester diméthylique d'un autre acide dicarboxylique aromatique, la (les) substitution(s) ayant lieu dans une quantité comprise entre 4 et 15 moles % pour l'éthylèneglycol et/ou le diméthyltéréphtalate.

2. Précurseur de plaque d'impression planographique selon la revendication 1, caractérisé en ce que le copolymère est le produit de la réaction de polycondensation d'éthylèneglycol et d'acide téréphtalique, l'acide téréphtalique étant substitué par de l'acide isophtalique dans une quantité comprise entre 4 et 15 moles %, ou le copolymère est le produit de la réaction de polycondensation d'éthylèneglycol et de diméthyltéréphtalate, le diméthyltéréphtalate étant substitué par du diméthylisophtalate dans une quantité comprise entre 4 et 15 moles %.

3. Précurseur de plaque d'impression planographique selon la revendication 1, caractérisé en outre en ce que l'épaisseur moyenne du support de résine thermoplastique s'élève à 290 µm.
